# EUROPEAN PATENT SPECIFICATION

(11) **EP 2 593 968 B1**
(45) Date of publication and mention of the grant of the patent: **03.04.2019**
(21) Application number: 11743316.9
(22) Date of filing: 08.07.2011
(51) Int. Cl.: H01L 31/0216, H01L 31/0224, C03C 17/36, H01L 31/18

(54) **TRANSPARENT FRONT ELECTRODE FOR A PHOTOVOLTAIC DEVICE**
TRANSPARENTE VORDERELEKTRODE FÜR EINE PHOTOVOLTAIKANORDNUNG
ÉLECTRODE AVANT TRANSPARENTE POUR UN DISPOSITIF PHOTOVOLTAÏQUE

(30) Priority: 13.07.2010 GB 201011729
(43) Date of publication of application: 22.05.2013
(73) Proprietor: Pilkington Group Limited, Lancashire, L40 5UF (GB)
(72) Inventor: MCSPORRAN, Neil, Liverpool Merseyside L15 9HN (GB); NICHOL, Gary Robert, Warrington Cheshire WA3 4NQ (GB)
(74) Representative: Teasdale, Nicola Joanne
(86) International application number: PCT/GB2011/051282
(87) International publication number: WO 2012/007737

(56) References cited:
- WO-A1-2009/001143
- WO-A2-2007/110552
- WO-A2-2009/099509
- WO-A2-2010/036776

## Description

This invention relates to the field of photovoltaic devices, in particular photovoltaic devices comprising silver-based transparent front electrodes.

Photovoltaic (PV) devices or solar cells are material junction devices which convert sunlight into direct current (DC) electrical power. When exposed to sunlight (consisting of energy from photons), the electric field of solar cell p-n junctions separates pairs of free electrons and holes, thus generating a photo-voltage. A circuit from n-side to p-side allows the flow of electrons when the solar cell is connected to an electrical load, while the area and other parameters of the PV cell junction device determine the available current. Electrical power is the product of the voltage times the current generated as the electrons and holes recombine.

It is to be understood that in the context of the present invention the term "photovoltaic device" includes any assembly of components generating the production of an electric current between its electrodes by conversion of solar radiation, whatever the dimensions of the assembly, the voltage and the intensity of the produced current, and whether or not this assembly of components presents one or more internal electrical connection(s) (in series and/or parallel). The term "photovoltaic device" within the meaning of the present invention is thus here equivalent to "photovoltaic module" or "photovoltaic panel", as well as "photovoltaic cell".

Solar cells have evolved significantly over the past three decades, with experimental efficiencies increasing from less than about 5% in 1980 to almost 40% in 2008. The most common solar cell material is silicon, which is in the form of single or polycrystalline wafers. Because the amortized cost of forming silicon-based solar cells to generate electricity is higher than the cost of generating electricity using traditional methods, there has been an effort to reduce the cost to form solar cells. In particular, thin-film techniques enable streamlined, high-volume manufacturing of solar cells and greatly reduced silicon consumption.

Photovoltaic cells rely on substances known as semiconductors. Semiconductors are insulators in their pure form, but are able to conduct electricity when heated or combined with other materials. A semiconductor mixed, or "doped," for example with phosphorous develops an excess of free electrons. This is known as an n-type semiconductor. A semiconductor doped with other materials, such as boron, develops an excess of "holes," spaces that accept electrons. This is known as a p-type semiconductor.

A PV cell joins n-type and p-type materials, with a layer in between known as a junction. Even in the absence of light, a small number of electrons move across the junction from the n-type to the p-type semiconductor, producing a small voltage. In the presence of light, photons dislodge a large number of electrons, which flow across the junction to create a current which can be used to power electrical devices.

Traditional solar cells use silicon in the n-type and p-type layers. The newest generation of thin-film solar cells uses thin layers of cadmium telluride (CdTe), amorphous or microcrystalline silicon, or copper indium gallium deselenide (CIGS) instead.

The semiconductor junctions are formed in different ways, either as a p-i-n device in amorphous silicon (a-Si), or as a hetero-junction (e.g. with a thin cadmium sulphide layer that allows most sunlight to pass through) for CdTe and CIGS. In their simplest form, a-Si cells suffer from significant degradation in their power output (in the range 15-35%) when exposed to the sun. Better stability requires the use of thinner layers, however, this reduces light absorption and hence cell efficiency. This has led the industry to develop tandem and even triple layer devices that contain p-i-n cells stacked on top of each other.

A transparent conductive oxide (TCO) layer forms the front electrical contact of the cell, and a metal layer forms the rear contact. The TCO may be based on doped zinc oxide (e.g. ZnO:Al [ZAO] or ZnO:B), tin oxide doped with fluorine (SnO₂:F) or an oxide material of indium and tin (ITO). These materials are deposited chemically, such as for example by chemical vapor deposition ("CVD"), or physically, such as for example by vacuum deposition by magnetron sputtering.

Cadmium telluride-based PV devices have been significantly refined over the past few years and are capable of being produced in high volume and at low cost. Cadmium telluride is an excellent semiconductor for solar cells because its bandgap of 1.5 electron-volts is matched nearly perfectly to the solar spectrum. This allows CdTe-based devices to absorb more of the available solar energy in low and diffuse light situations - such as at dawn and dusk and under cloudy skies - and convert it into electricity more efficiently than conventional cells.

WO2009103929 describes a PV device with a silver-based metallic functional layer. The device incorporates a thick ZAO TCO layer in order to achieve the desired conductivity, although such a layer would be difficult to prepare without a heating step during processing. An additional heating step would make the device more difficult and costly to manufacture. Furthermore, example 2 of WO2009103929 boasts a ZnSnOₓ anti-reflecting layer with a resistivity of 1 Ω.cm. This value would be difficult to achieve given the inherent dielectric nature of ZnSnOₓ. Additionally, the device of WO2009103929 utilises a thick SiO₂ layer which would be undesirable for production reasons.

WO2009099509 discloses a front electrode for use in a photovoltaic device comprising a glass substrate, a dielectric later, a silver seed layer, a silver based IR reflecting layer, a contact layer, a TCO, and a buffer layer. However, such a stack has certain processing limitations.

WO2010063973 also describes a PV device with a silver-based metallic functional layer. Likewise, this device utilises a thick ZAO TCO layer which would present processing difficulties. Furthermore, the devices of WO2009103929, WO2009099509, and WO2010063973 would not exhibit optimal durability upon heat treatment.

WO2009001143 discloses a coated glass pane with a low-e and/or solar control coating having a lower anti-reflection layer comprising a base layer of an (oxi)nitride of aluminium. The document further discloses that if the base layer of an (oxi)nitride of aluminium (AlNₓ) is replaced with an (oxi)nitride of silicon (SiNₓ) the layers are visibly damaged by heat treatment.

Accordingly, the need exists for silver-based PV devices that have improved durability during manufacture, storage, transport and in use. The high processing temperatures used in the manufacture of CdTe PV cells and other devices can be prohibitive in the case of some known devices. Moreover, it is known that the efficiency of CdTe PV cells improves with higher processing temperatures and therefore increased durability is especially advantageous. Similarly, it is attractive to provide PV devices that can survive the mechanical and chemical conditions during usual handling and processing steps without significant damage. Furthermore, it is also desirable to provide PV devices wherein the layers have a smoother morphology than would be obtained using atmospheric CVD, as this reduces the number of pinholes in CdS in CdTe cells and the subsequent shorting in the device. Smoother morphology can be achieved using sputtering, which can cover a large area quickly and is suited to the deposition of silver and buffer layers such as ZnSnOₓ. Within the terms of the present invention a buffer layer is defined as a film (or combination of films) of resistive material located between a conductive layer and an absorber material, which helps to reduce shunting in a PV device. For example WO0014812A1 describes a ZnSnOx buffer layer for a CdS/CdTe device. However, the buffer layer does not have to be ZnSnOx, as other materials such as SnO₂ and In₂O₃ have been shown to be useful buffer layers (Ferekides et al, Thin Solid Films, 480-481, (2005), 224.). In contrast, the deposition of silver and buffer layers is difficult via CVD. Additionally, it is attractive to produce PV devices with lower sheet resistance, higher light transmittance and improved buffer layer performance. It is also desirable to provide a silver-based transparent front electrode that can be easily manufactured in a cost effective manner with no additional heating required.

According to a first aspect of the present invention there is provided a transparent front electrode for a photovoltaic device comprising at least the following layers in sequence:
- a glass substrate;
- a lower anti-reflection layer, comprising in sequence from the glass substrate
   ∘ a base layer of an (oxi)nitride of silicon,
   ∘ a middle layer of an oxide of Zn and Sn,
   ∘ a top layer of an oxide of Zn;
- a silver-based functional layer; and
- an upper anti-reflection layer comprising in sequence from the silver-based functional layer
   ∘ a first barrier layer of an oxide of Ni and Cr,
   ∘ a second barrier layer of an Al-doped oxide of Zn, and
   ∘ a buffer layer;
wherein the first barrier layer of an oxide of Ni and Cr is located directly in contact with the silver-based functional layer or the first barrier layer of an oxide of Ni and Cr is separated from the silver-based functional layer by one or more additional barrier layers.

The transparent front electrodes and photovoltaic devices (see below) of the present invention can be readily manufactured and exhibit excellent sheet resistance, light transmittance and buffer layer performance.

The manufacturing costs of the electrodes of the present invention are not prohibitive because manufacture involves deposition at room temperature and can be achieved in much thinner layers than with conventional electrodes. Additionally, the electrodes of the present invention are surprisingly chemically and mechanically robust and can withstand the necessary high processing temperatures used in the manufacture of CdTe PV cells and other devices. Therefore, the front electrode of the present invention can be manufactured on existing production coaters whereas the manufacture of the front electrodes described in WO2009103929 and WO2010063973 would be more difficult and costly. In addition, the base layer of an (oxi)nitride of silicon in the electrode of the present invention can be much thinner than the SiO₂ layer in the device of WO2009103929.

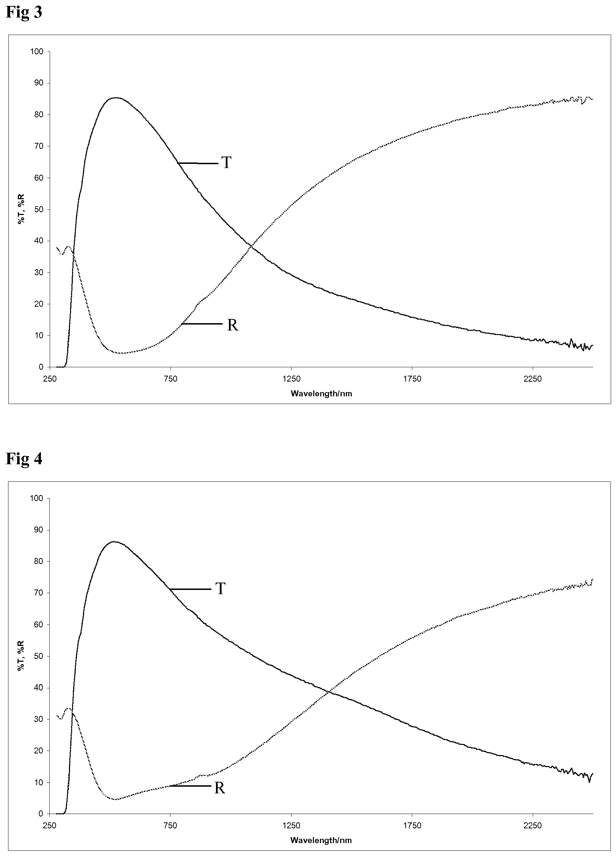

The use of the silver based transparent front electrode as in the present invention is also advantageous because a very low sheet resistance can be achieved through the use of a thinner metallic layer. Modification of the thickness of the silver layer enables the optimisation of the sheet resistance/transmission balance. Although low sheet resistance is attractive, it is desirable not to go below around 5-15 ohm/sq (if sheet resistance is too low the conductivity is excessively high so the layer(s) in question can provide a pathway for shorts) and so by aiming for this value after heat treatment it is possible to achieve a high transmission. This is illustrated in Figure 4 which shows plots of % light transmittance and % light reflectance versus wavelength for an electrode with a silver layer of 6nm thickness (Example 4).

The present invention provides advantages over devices that utilise for instance a SnO₂:F TCO, that are manufactured by chemical vapour deposition (CVD) because the electrodes and devices of the present invention exhibit at least equal sheet resistance but with a higher light transmission. Furthermore, the roughness of layers deposited by CVD is a problem since greater texture increases the number of pinholes and the potential for subsequent shorting in devices that utilise CdTe-based photovoltaic material layers. Electrodes and devices of the present invention are ideally suited to manufacture via sputtering which affords smoother morphology and therefore makes the layers less susceptible to pinholes. Due to the poor electrical properties of CdS, all photo-generated carriers recombine in this material and do not contribute to the output photocurrent. Therefore a thinner CdS layer is desirable, but this increases the risk of shunts. The electrodes and devices of the present invention enable the CdS window layer to be thinned which improves short circuit current (Jsc) at the blue end of the spectrum, without suffering from shunts.

In addition, by tailoring the thicknesses of the various layers in the upper anti-reflection layer the capability of the PV device to withstand higher temperatures, such as those found during the manufacture of CdTe-based PV devices, is further improved.

The base layer of an (oxi)nitride of silicon and/or an (oxi)nitride of aluminium may have a thickness of at least 5 nm, preferably from 5 to 65 nm, more preferably from 10 to 60 nm, even more preferably from 15 to 55 nm, in some embodiments even more preferably from 15 to 24 nm, in other embodiments even more preferably from 30 to 55 nm. This base layer serves as a glass side diffusion barrier.

The term "(oxi)nitride of silicon" encompasses both Si nitride (SiNₓ) and Si oxinitride (SiOₓN_{y}) whilst the term "(oxi)nitride of aluminium" encompasses both Al nitride (AlNₓ) and Al oxinitride (AlOₓN_{y}). Si nitride, Si oxynitride, Al nitride and Al oxinitride layers are preferably essentially stoichiometric (e.g. Si nitride = Si₃N₄, x = 1.33) but may also be substoichiometric or even super-stoichiometric, as long as the heat treatability of the coating is not negatively affected thereby.

Layers of an (oxi)nitride of silicon and/or an (oxi)nitride of aluminium may be sputtered from Si- and/or Al-based targets respectively in a sputtering atmosphere containing nitrogen and argon. An oxygen content of the base layer of an (oxi)nitride of silicon and/or an (oxi)nitride of aluminium may result from residual oxygen in the sputtering atmosphere or from a controlled content of added oxygen in said atmosphere. It is generally preferred if the oxygen content of the silicon (oxi)nitride and/or aluminium (oxi)nitride is significantly lower than its nitrogen content, i.e. if the atomic ratio O/N in the layer is kept significantly below 1. It is most preferred to use Si nitride and/or aluminium nitride with negligible oxygen content for the base layer of the lower anti-reflection layer. This feature may be controlled by making sure that the refractive index of the layer does not differ significantly from the refractive index of an oxygen-free Si nitride and/or aluminium nitride layer.

It is within the scope of the invention to use doped or mixed Si and/or Al targets or to otherwise add metals or semiconductors to the Si and/or Al component of this layer as long as the essential barrier and protection property of the base layer of the lower anti-reflection layer is not lost. A well known and established dopant for Si targets is Al, other dopants not being excluded. Dopants may be typically present in amounts of up to about 5 - 15 wt.%. Al is usually present in Al-doped Si targets in an amount of about 10 wt.%.

A further dielectric layer may be provided as part of the lower anti-reflection layer, particularly arranged immediately on the glass substrate and below the base layer of an (oxi)nitride of silicon and/or aluminium, e.g. a layer having a high refractive index or providing an additional diffusion barrier function. A dielectric material having a refractive index at 550 nm of at least about 2.2, more preferably of at least about 2.3, is particularly recommended for such purpose. A particularly suitable material for such additional high refracting dielectric layer is an oxide of titanium (TiO₂). It is particularly preferred to use a medium-frequency-sputtered oxide of titanium for such additional dielectric layer, and it is preferred to deposit the titanium oxide layer in a sputtering atmosphere to which no nitrogen is added.

The middle layer of an oxide of Zn and Sn serves to improve stability during a heat treatment by providing a dense and thermally stable layer and contributing to reduce the haze after a heat treatment. The middle layer also reduces the sheet resistance of the device by improving the quality of the subsequently deposited silver-based functional layer, as compared to certain other known dielectric layers. The middle layer of an oxide of Zn and Sn may have a thickness of at least 2 nm, preferably from 2 to 25 nm, more preferably from 2 to 20 nm, even more preferably from 2 to 15 nm, even more preferably from 3 to 12 nm, even more preferably from 3 to 10 nm, even more preferably from 3 to 6 nm, most preferably from 3 to 5 nm.

A thickness of said middle layer of at least about 3 nm can contribute significantly to improving the sheet resistance of the subsequently deposited silver-based functional layer. An upper thickness limit of about 25 nm is preferred due to optical interference conditions and by a reduction of heat treatability due to the resulting reduction in the thickness of the base layer that would be needed to maintain the optical interference boundary conditions for anti-reflecting the silver-based functional layer.

The middle layer is preferably located directly on the base layer of an (oxi)nitride of silicon and/or an (oxi)nitride of aluminium.

The middle layer of an oxide of Zn and Sn (abbreviation: ZnSnOₓ) preferably comprises about 10 - 90 wt.% Zn and 90 - 10 wt.% Sn, more preferably about 40 - 60 wt.% Zn and about 40 - 60 wt.% Sn, preferably about 50 wt.% each of Zn and Sn, in wt.% of its total metal content.

The top layer of an oxide of Zn may be doped with metals such as Al or Sn. This top layer of a metal oxide serves as a growth promoting layer for the silver-based functional layer deposited thereafter. The top layer of an oxide of Zn may have a thickness of at least 2 nm, preferably from 2 to 15 nm, more preferably from 3 to 12 nm, even more preferably from 5 to 12 nm, even more preferably between 7 to 9 nm.

This top layer may be doped with metals in an amount of up to about 10 wt.% (wt.% referring to the target metal content). A typical Zn dopant content is about 2 wt.%, Al being preferred as such Zn dopant. ZnO and doped (mixed) Zn oxides have proven very effective as a growth promoting layer that assists in achieving a low sheet resistance at a given thickness of the subsequently deposited silver-based functional layer. It is preferred if the top layer of the lower anti-reflection layer is reactively deposited from a metallic target.

This at least triple layer lower anti-reflection layer provides superior performance in subsequent high temperature processing steps which helps to maintain the quality of the silver-based functional layer following toughening.

The overall thicknesses of both the lower and upper anti-reflection layers as well as of any central anti-reflection layer located between two silver-based functional layers are chosen, as is well known in the art, such that they can serve their basic function of anti-reflecting the silver-based functional layer(s) by optical interference and provide the coated glass pane with a pleasing appearance or with a desired colour in reflection or transmission. To achieve the desired anti-reflection property the lower anti-reflection layer will typically have a total geometrical thickness of about 20 - 70 nm and the upper anti-reflection layer will typically have a total geometrical thickness of about 20 - 130 nm.

The thickness of the silver-based functional layer is preferably from 5 to 15 nm, more preferably from 5 to 12 nm, even more preferably from 5 to 11 nm, even more preferably from 8 to 11 nm, most preferably from 9 to 11 nm. With such a layer thickness a sheet resistance of 5 ohm/sq can readily be achieved for the device. Light transmittance values of above 86 % after a heat treatment can be easily achieved for single silver coatings.

The first barrier layer of an oxide of Ni and Cr may have a thickness of up to 5 nm, preferably less than or equal to 3 nm, more preferably less than or equal to 2 nm, even more preferably from 0.5 to 2 nm, most preferably from 1 to 2 nm. Such barrier layer thicknesses enable ease of deposition whilst still providing superior durability, particularly at high temperatures.

The second barrier layer of an Al-doped oxide of Zn in the upper anti-reflection layer may have a thickness of from 0.5 to 20 nm, preferably from 0.5 to 10 nm, more preferably from 1 to 7 nm, even more preferably from 1 to 5 nm, most preferably from 2 to 4 nm. Such barrier layer thicknesses enable ease of deposition whilst still providing superior durability, particularly at high temperatures.

Preferably the first barrier layer of an oxide of Ni and Cr is located in direct contact with the silver-based functional layer. Preferably the first barrier layer of an oxide of Ni and Cr is located in direct contact with the second barrier layer of an Al-doped oxide of Zn.

The additional barrier layers may comprise one or more layers of NiCr, NiCrOₓ, Ti, TiOₓ, Zr, ZrOₓ, InSnOₓ, or combinations thereof. Said additional barrier layers may have a thickness of up to 5 nm, preferably from 0 to 3 nm, more preferably from 0 to 2 nm, even more preferably from 0.5 to 2 nm, most preferably from 1 to 2 nm.

The barrier layers are able to protect the silver-based functional layer during the deposition of the upper anti-reflection layer and during a heat treatment of the coated glass pane. It has been found that a superior protection of the silver-based functional layer during the deposition process and a high optical stability during a heat treatment can be achieved if the barrier layer comprises a layer of a (doped) metal oxide sputtered from a (doped) metal oxide target.

The upper anti-reflection layer may have a total thickness of from 20 to 130 nm, preferably from 30 to 100 nm, more preferably from 30 to 60 nm, even more preferably from 40 to 50 nm.

The targets of an Al-doped oxide of Zn, of Ti oxide and of In oxide or of an In-based alloy oxide mentioned before may be at least slightly suboxidic to increase their electrical conductivity and to simplify the sputter deposition process for the - optionally slightly suboxidic - Al-doped zinc oxide (ZnOₓ:Al), Ti oxide or In or In-based alloy oxide barrier layers. While sputtering in a coating atmosphere containing a controlled small amount of added oxygen may be appropriate, it is preferred if the coating atmosphere contains only a minimum amount of oxygen.

Preferably the upper anti-reflection layer comprises a layer of an (oxi)nitride of aluminium and/or an (oxi)nitride of silicon. Preferably said layer of an (oxi)nitride of aluminium and/or an (oxi)nitride of silicon is located between the layer of an Al-doped oxide of Zn and the buffer layer.

Said optional layer of an (oxi)nitride of aluminium and/or an (oxi)nitride of silicon in the upper anti-reflection layer may have a thickness of from 0 to 30 nm, preferably at least 2 nm, more preferably at least 3 nm, even more preferably from 5 to 30 nm, even more preferably from 10 to 30 nm, even more preferably from 10 to 20 nm, most preferably from 12 to 15 nm.

The optional layer of an (oxi)nitride of aluminium and/or an (oxi)nitride of silicon, which can in some cases make up a major part of the upper anti-reflection layer, provides stability and diffusion barrier properties. This layer provides better protection during heat treatments such as the high temperature CdTe recrystallisation stage, wherein the layer facilitates the formation of a conductive path. It is preferably deposited in an essentially oxygen-free atmosphere as an AlN layer. The layer of an (oxi)nitride of aluminium or an (oxi)nitride of silicon of the upper anti-reflection layer is preferably in direct contact with the layer of an Al-doped oxide of Zn in the upper anti-reflection layer as defined herein without any intervening further dielectric layer.

The buffer layer of the upper anti-reflection layer (the top dielectric) may comprise one or more layers of an oxide of Zn and Sn and/or SnO₂. The buffer layer may have a thickness of from 8 to 125 nm, preferably at least 10 nm, more preferably at least 15 nm, even more preferably from 20 to 80 nm, even more preferably from 25 to 50 nm, most preferably from 25 to 35 nm. When the buffer layer is an oxide of Zn and Sn, it preferably comprises about 10 - 90 wt.% Zn and 90 - 10 wt.% Sn, more preferably about 40 - 60 wt.% Zn and about 40 - 60 wt.% Sn, preferably about 50 wt.% each of Zn and Sn, in wt.% of its total metal content.

A buffer layer of an oxide of Zn and Sn and/or SnO₂ acts as a particularly good buffer layer for CdTe-based PV devices. Furthermore, the buffer layer of course also provides anti-reflection properties.

Other benefits of the present invention include the low sheet resistance of the silver-based functional layer and the compatibility of ZnSnOₓ and SnO₂ with CdS.

According to another aspect of the present invention there is provided a photovoltaic device comprising at least the following layers in sequence:
- a glass substrate;
- a lower anti-reflection layer, comprising in sequence from the glass substrate
   ∘ a base layer of an (oxi)nitride of silicon and/or an (oxi)nitride of aluminium,
   ∘ a middle layer of an oxide of Zn and Sn,
   ∘ a top layer of an oxide of Zn;
- a silver-based functional layer;
- an upper anti-reflection layer comprising in sequence from the silver-based functional layer
   ∘ a first barrier layer of an oxide of Ni and Cr,
   ∘ a second barrier layer of an Al-doped oxide of Zn, and
   ∘ a buffer layer;
- a photovoltaic material layer; and
- a back contact or electrode layer;
wherein the first barrier layer of an oxide of Ni and Cr is located directly in contact with the silver-based functional layer or the first barrier layer of an oxide of Ni and Cr is separated from the silver-based functional layer by one or more additional barrier layers.

The PV device advantageously utilises a CdTe-based photovoltaic material layer comprising a layer of CdS and a layer of CdTe, wherein the layer of CdS is adjacent to the buffer layer. Alternatively, the PV device of the present invention may utilise thin film a-Si or tandem-Si -based photovoltaic material layers.

The back contact or electrode layer may be ZnO doped with Al or B.

The thermal stability of PV devices according to the invention is reflected by the fact that the haze value of heat treated PV devices does not exceed significantly 0.2 % and particularly remains at or below about 0.1 %. Larger increases in the haze value if detected during a heat treatment would indicate that the coating is beginning to be damaged.

It goes without saying that PV devices according to the invention will not necessarily survive without damage more than one heat treatment and that all comparison values before and after heat treatment refer to a comparison between a non-heat treated PV device and a PV device heat treated once.

According to another aspect of the present invention there is provided a method of manufacturing a transparent front electrode for a photovoltaic device in accordance with the first aspect comprising providing a glass substrate and successively applying to said glass substrate
- a lower anti-reflection layer, comprising in sequence from the glass substrate
   ∘ a base layer of an (oxi)nitride of silicon and/or an (oxi)nitride of aluminium,
   ∘ a middle layer of an oxide of Zn and Sn,
   ∘ a top layer of an oxide of Zn;
- a silver-based functional layer; and
- an upper anti-reflection layer comprising in sequence from the silver-based functional layer
   ∘ a first barrier layer of an oxide of Ni and Cr,
   ∘ a second barrier layer of an Al-doped oxide of Zn, and
   ∘ a buffer layer;
wherein the first barrier layer of an oxide of Ni and Cr is located directly in contact with the silver-based functional layer or the first barrier layer of an oxide of Ni and Cr is separated from the silver-based functional layer by one or more additional barrier layers.

The invention is not limited to a specific production process for the device. However, it is particularly preferred if at least one of the layers and most preferably all layers are applied by magnetron cathode sputtering, either in the DC mode, in the medium frequency mode or in any other suitable mode, whereby metallic or semiconducting targets are sputtered reactively or non-reactively in a suitable sputtering atmosphere. Depending on the materials to be sputtered planar or rotating tubular targets may be used.

The coating process is preferably carried out such that the layers are deposited in stoichiometric quantities.

Particularly high quality electrodes can be achieved if at least one of the partial layers of the lower anti-reflection layer is medium-frequency sputtered from metal or metal oxide targets. Medium-frequency sputtering is well known in the art of sputter deposition and encompasses AC sputtering of two or more targets at a frequency in the range of about 5 - 200 kHz.

According to another aspect of the present invention there is provided a method of manufacturing a photovoltaic device in accordance with the present invention comprising providing a transparent front electrode in accordance with the first aspect and successively applying to the buffer layer
- a photovoltaic material layer; and
- a back contact or electrode layer.

According to another aspect of the present invention there is provided a building incorporating a photovoltaic device in accordance with the first aspect.

According to another aspect of the present invention there is provided an organic light emitting diode (OLED) comprising
- a glass substrate;
- a lower anti-reflection layer, comprising in sequence from the glass substrate
   ∘ a base layer of an (oxi)nitride of silicon and/or an (oxi)nitride of aluminium,
   ∘ a middle layer of an oxide of Zn and Sn,
   ∘ a top layer of an oxide of Zn;
- a silver-based functional layer;
- an upper anti-reflection layer comprising in sequence from the silver-based functional layer
   ∘ a first barrier layer of an oxide of Ni and Cr,
   ∘ a second barrier layer of an Al-doped oxide of Zn, and
   ∘ a buffer layer;
- a photovoltaic material layer; and
- a back contact or electrode layer;
wherein the first barrier layer of an oxide of Ni and Cr is located directly in contact with the silver-based functional layer or the first barrier layer of an oxide of Ni and Cr is separated from the silver-based functional layer by one or more additional barrier layers.

It will be appreciated that optional features applicable to one aspect of the invention can be used in any combination, and in any number. Moreover, they can also be used with any of the other aspects of the invention in any combination and in any number. This includes, but is not limited to, the dependent claims from any claim being used as dependent claims for any other claim in the claims of this application.

Embodiments of the present invention will now be described herein, by way of example only, with reference to the following figures:
**Figure 1** shows a schematic cross sectional view of a transparent front electrode for a photovoltaic device in accordance with the present invention;
**Figure 2** shows a schematic cross sectional view of a photovoltaic device in accordance with the present invention;
**Figure 3** shows plots of % light transmittance (T) and % light reflectance (R) versus wavelength for the electrode of Example 1; and
**Figure 4** shows plots of % light transmittance (T) and % light reflectance (R) versus wavelength for the electrode of Example 4.

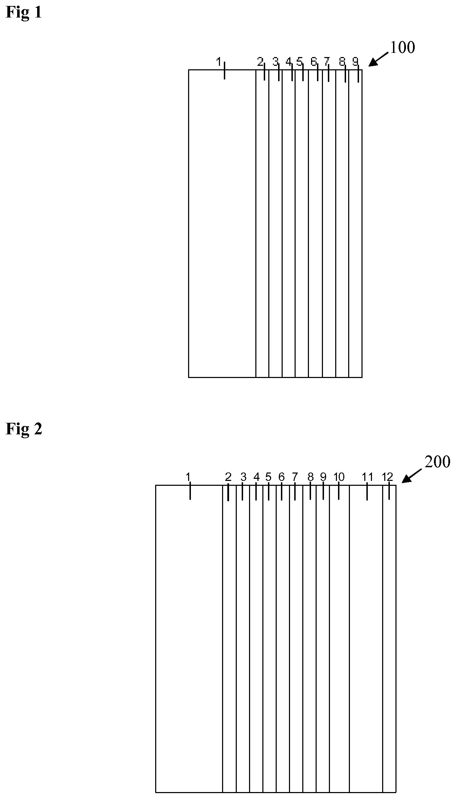

Figure 1 shows a schematic cross sectional view of an embodiment of an electrode 100 in accordance with the present invention. The layers are successively glass 1, SiₓN_{y} 2, ZnSnOₓ 3, ZnO 4, Ag 5, NiCrOₓ 6, ZAO 7, SiₓN_{y} 8, ZnSnOₓ 9.

Figure 2 shows a schematic cross sectional view of an embodiment of a photovoltaic device 200 in accordance with the present invention. The layers are the same as in the electrode 100 of figure 1 but additionally, after the ZnSnOₓ 9 layer, there are successively layers of CdS 10, CdTe 11 and a back contact 12 of ZnO doped with Al.

For all Examples the coatings were deposited on 4 mm thick standard float glass panes with a light transmittance of about 89 % using AC and/or DC magnetron sputtering devices, medium-frequency sputtering being applied where appropriate.

All dielectric layers of an oxide of Zn and Sn (ZnSnOₓ, weight ratio Zn : Sn ≈ 50 : 50) were reactively sputtered from zinc-tin targets in an Ar/O₂ sputter atmosphere.
The ZnO:Al growth promoting top layers of the lower anti-reflection layers were sputtered from Al-doped Zn targets (Al content about 2 wt.%) in an Ar/O₂ sputter atmosphere.

The functional layers that in all Examples consisted of essentially pure silver were sputtered from silver targets in an Ar sputter atmosphere without any added oxygen and at a partial pressure of residual oxygen below 10⁻⁵ mbar.

The barrier layers of (slightly substoichiometric, low light absorbing) Al-doped zinc oxide (ZnO:Al) were sputtered from conductive ZnOₓ:Al targets in a pure Ar sputter atmosphere without added oxygen.

The suboxidic NiCrOₓ barrier layers were sputtered from Ni₈₀Cr₂₀ targets in an Ar / O₂ sputter atmosphere.

The layers of aluminium nitride (AlN) were reactively sputtered from Al targets in an Ar/N₂ sputter atmosphere containing only residual oxygen.

The layers of silicon nitride (Si₃N₄) were reactively sputtered from Al-doped Si targets in an Ar/N₂ sputter atmosphere containing only residual oxygen.

Examples of transparent front electrodes ("stacks") according to the present invention were heat treated in a muffle furnace at 650 °C for 5 minutes. The intention is to replicate as closely as possible the conditions that the electrode will experience during solar cell fabrication.

Table 1 below shows five examples of different transparent front electrodes according to the present invention. Table 1 displays the sequence of layers from the glass pane, layer thicknesses in nm, % light transmittance and sheet resistance in ohm/square.
Example 1: This electrode utilises a 10nm Ag layer in order to minimise sheet resistance whilst still providing high light transmittance. The NiCrOx barrier layer provides the Ag layer with additional protection to heat. Figure 3 shows plots of % light transmittance and % light reflectance versus wavelength for this electrode.
Example 2: This electrode uses a thinner, 8nm, Ag layer to afford low sheet resistance and an increase in light transmittance. The top and bottom dielectric layers have been adjusted to minimise reflection.
Example 3: A thinner (7nm) Ag layer again results in an electrode that exhibits low sheet resistance and high light transmittance.
Example 4: This electrode has an even thinner (6nm) Ag layer but still exhibits low sheet resistance and high light transmittance. Figure 4 shows plots of % light transmittance and % light reflectance versus wavelength for the electrode of Example 4.
Example 5: This electrode uses solely zinc stannate in the top dielectric. Generally, the barrier layer and upper anti-reflection layer may be optimised to fit different deposition processes for instance in CdS/CdTe PV device manufacture.

**Table 1: Layer sequence from the glass pane, layer thicknesses in nm, % light transmittance and sheet resistance of various electrodes according to the present invention, wherein**

| **Material** | **Example 1** | **Example 2** | **Example 3** | **Example 4** | **Example 5** |
|---|---|---|---|---|---|
| **SiₓN_{y}** | 43 | 44 | 51 | 56 | 37 |
| **ZnSnOₓ** | 5 | 5 | 5 | 5 | 5 |
| **ZnO** | 8 | 8 | 8 | 8 | 8 |
| **Ag** | 10 | 8 | 7 | 6 | 10 |
| **NiCrOₓ** | 2 | 2 | 2 | 2 | 1 |
| **ZAO** | 3 | 3 | 3 | 3 | 3 |
| **SiₓN_{y}** | 28 | 28 | 28 | 28 | 0 |
| **ZnSnOₓ** | 6 | 14 | 14 | 16 | 41 |
| **%T (AD)** | 84.7 | 86.5 | 86.5 | 84.2 | 83.6 |
| **%T (HT)** | 88.9 | 89.1 | 89.0 | 87.7 | 87.9 |
| **Rs (AD)** | 7.1 | 8.5 | 9.5 | 12.2 | 8 |
| **Rs (HT)** | 4.2 | 5.2 | 6.2 | 7.3 | 4.6 |

| | | | | | |
|---|---|---|---|---|---|
| %T (AD) = % light transmittance (as deposited) % T (HT) = % light transmittance (following heat treatment) Rs (AD) = sheet resistance (as deposited) in ohm/square Rs (HT) = sheet resistance (following heat treatment) in ohm/square | | | | | |

The above examples demonstrate the wide range of possible arrangements available for electrodes according to the present invention. This flexibility enables the specific tailoring of electrodes to suit particular processes. For instance, electrodes according to the present invention can be designed to suit mild or harsh processing conditions. Furthermore, all of the above examples exhibit excellent light transmittance and sheet resistance characteristics in comparison with known electrodes.

## Claims

1. A transparent front electrode (100) for a photovoltaic device comprising at least the following layers in sequence:
- a glass substrate (1);
- a lower anti-reflection layer, comprising in sequence from the glass substrate (1)
∘ a base layer of an (oxi)nitride of silicon (2),
∘ a middle layer of an oxide of Zn and Sn (3),
∘ a top layer of an oxide of Zn (4);
- a silver-based functional layer (5); and
- an upper anti-reflection layer comprising in sequence from the silver-based functional layer
∘ a first barrier layer of an oxide of Ni and Cr (6),
∘ a second barrier layer of an Al-doped oxide of Zn (7), and
∘ a buffer layer (8, 9);
wherein the first barrier layer of an oxide of Ni and Cr (6) is located directly in contact with the silver-based functional layer (5) or the first barrier layer of an oxide of Ni and Cr (6) is separated from the silver-based functional layer (5) by one or more additional barrier layers.

2. The electrode according to claim 1, wherein the base layer of an (oxi)nitride of silicon (2) has a thickness of from 15 to 55 nm.

3. The electrode according to claim 1 or claim 2, wherein the middle layer of an oxide of Zn and Sn (3) has a thickness of from 3 to 12 nm.

4. The electrode according to any preceding claim, wherein the middle layer of an oxide of Zn and Sn (3) is located directly on the base layer of an (oxi)nitride of silicon (2).

5. The electrode according to any preceding claim, wherein the top layer of an oxide of Zn (4) has a thickness of from 3 to 12 nm.

6. The electrode according to any preceding claim, wherein the silver-based functional layer (5) has a thickness of from 5 to 11 nm.

7. The electrode according to any preceding claim, wherein the first barrier layer of an oxide of Ni and Cr (6) has a thickness of less than or equal to 3 nm.

8. The electrode according to any preceding claim, wherein the second barrier layer of an Al-doped oxide of Zn (7) in the upper anti-reflection layer has a thickness of from 0.5 to 20 nm.

9. The electrode according to any preceding claim, wherein said additional barrier layers comprise one or more layers of NiCr, NiCrOₓ, Ti, TiOₓ, Zr, ZrOₓ, InSnOₓ, or combinations thereof.

10. The electrode according to any preceding claim, wherein the upper anti-reflection layer has a total thickness of from 20 to 130 nm.

11. The electrode according to any preceding claim, wherein the buffer layer (8, 9) comprises one or more layers of an oxide of Zn and Sn and/or SnO₂.

12. The electrode according to any preceding claim, wherein the buffer layer (8, 9) has a thickness of from 8 to 125 nm.

13. A photovoltaic device (200) comprising at least the following layers in sequence:
- a glass substrate (1);
- a lower anti-reflection layer, comprising in sequence from the glass substrate
∘ a base layer of an (oxi)nitride of silicon (2),
∘ a middle layer of an oxide of Zn and Sn (3),
∘ a top layer of an oxide of Zn (4);
- a silver-based functional layer (5);
- an upper anti-reflection layer comprising in sequence from the silver-based functional layer
∘ a first barrier layer of an oide of Ni and Cr (6),
∘ a second barrier layer of an Al-doped oxide of Zn (7), and
∘ a buffer layer (8, 9);
- a photovoltaic material layer (10, 11); and
- a back contact or electrode layer (12);
wherein the first barrier layer of an oxide of Ni and Cr (6) is located directly in contact with the silver-based functional layer (5) or the first barrier layer of an oxide of Ni and Cr (6) is separated from the silver-based functional layer (5)_by one or more additional barrier layers.

14. A method of manufacturing a transparent front electrode (100) for a photovoltaic device in accordance with any of claims 1 to 12 comprising providing a glass substrate (1) and successively applying to said glass substrate (1)
- a lower anti-reflection layer, comprising in sequence from the glass substrate (1)
∘ a base layer of an (oxi)nitride of silicon (2),
∘ a middle layer of an oxide of Zn and Sn (3),
∘ a top layer of an oxide of Zn (4);
- a silver-based functional layer (5); and
- an upper anti-reflection layer comprising in sequence from the silver-based functional layer
∘ a first barrier layer of an oxide of Ni and Cr (6),
∘ a second barrier layer of an Al-doped oxide of Zn (7), and
∘ a buffer layer (8, 9);
wherein the first barrier layer of an oxide of Ni and Cr (6) is located directly in contact with the silver-based functional layer (5) or the first barrier layer of an oxide of Ni and Cr (6) is separated from the silver-based functional layer (5) by one or more additional barrier layers.

15. An organic light emitting diode (OLED) comprising
- a glass substrate (1);
- a lower anti-reflection layer, comprising in sequence from the glass substrate
∘ a base layer of an (oxi)nitride of silicon (2),
∘ a middle layer of an oxide of Zn and Sn (3),
∘ a top layer of an oxide of Zn (4);
- a silver-based functional layer (5);
- an upper anti-reflection layer comprising in sequence from the silver-based functional layer
∘ a first barrier layer of an oxide of Ni and Cr (6),
∘ a second barrier layer of an Al-doped oxide of Zn (7), and
∘ a buffer layer (8, 9);
- a photovoltaic material layer (10, 11); and
- a back contact or electrode layer (12);
wherein the first barrier layer of an oxide of Ni and Cr (6) is located directly in contact with the silver-based functional layer (5) or the first barrier layer of an oxide of Ni and Cr (6) is separated from the silver-based functional layer (5) by one or more additional barrier layers.

## Patentansprüche

1. Transparente Frontelektrode (100) für eine Photovoltaikvorrichtung, die mindestens die folgenden Schichten in Folge umfasst:
- ein Glassubstrat (1);
- eine untere Antireflexschicht, die ausgehend vom Glassubstrat (1) nacheinander umfasst:
∘ eine Basisschicht aus einem Silizium-(Oxi)-Nitrid (2),
∘ eine mittlere Schicht aus einem Oxid von Zn und Sn (3),
∘ eine obere Schicht aus einem Zn-Oxid (4);
- eine Funktionsschicht (5) auf Silberbasis; und
- eine obere Antireflexschicht, die ausgehend von der Funktionsschicht auf Silberbasis nacheinander umfasst:
∘ eine erste Barriereschicht aus einem Oxid von Ni und Cr (6),
∘ eine zweite Barriereschicht aus einem mit Al dotierten Zn-Oxid (7), und
∘ eine Pufferschicht (8, 9);
wobei die erste Barriereschicht aus einem Oxid von Ni und Cr (6) direkt in Kontakt mit der Funktionsschicht (5) auf Silberbasis angeordnet ist oder die erste Barriereschicht aus einem Oxid von Ni und Cr (6) von der Funktionsschicht (5) auf Silberbasis durch eine oder mehrere zusätzliche Barriereschichten getrennt ist.

2. Elektrode nach Anspruch 1, bei der die Basisschicht aus einem Silizium-(Oxi)-Nitrid (2) eine Dicke von 15 bis 55 nm aufweist.

3. Elektrode nach Anspruch 1 oder Anspruch 2, bei der die mittlere Schicht aus einem Oxid von Zn und Sn (3) eine Dicke von 3 bis 12 nm aufweist.

4. Elektrode nach einem der vorhergehenden Ansprüche, bei der die mittlere Schicht aus einem Oxid von Zn und Sn (3) direkt auf der Basisschicht aus einem Silizium-(Oxi)-Nitrid (2) angeordnet ist.

5. Elektrode nach einem der vorhergehenden Ansprüche, bei der die obere Schicht aus einem Zn-Oxid (4) eine Dicke von 3 bis 12 nm aufweist.

6. Elektrode nach einem der vorhergehenden Ansprüche, bei der die Funktionsschicht auf Silberbasis (5) eine Dicke von 5 bis 11 nm aufweist.

7. Elektrode nach einem der vorhergehenden Ansprüche, bei der die erste Barriereschicht aus einem Oxid von Ni und Cr (6) eine Dicke von weniger als oder gleich 3 nm aufweist.

8. Elektrode nach einem der vorhergehenden Ansprüche, bei der die zweite Barriereschicht aus einem mit Al dotierten Zn-Oxid (7) in der oberen Antireflexschicht eine Dicke von 0,5 bis 20 nm aufweist.

9. Elektrode nach einem der vorhergehenden Ansprüche, bei der die zusätzlichen Barriereschichten eine oder mehrere Schichten aus NiCr, NiCrOₓ, Ti, TiOₓ, Zr, ZrOₓ, InSnOₓ oder Kombinationen derselben umfassen.

10. Elektrode nach einem der vorhergehenden Ansprüche, bei der die obere Antireflexschicht eine Gesamtdicke von 20 bis 130 nm aufweist.

11. Elektrode nach einem der vorhergehenden Ansprüche, bei der die Pufferschicht (8, 9) eine oder mehrere Schichten aus einem Oxid von Zn und Sn und/oder SnO₂ umfasst.

12. Elektrode nach einem der vorhergehenden Ansprüche, bei der die Pufferschicht (8, 9) eine Dicke von 8 bis 125 nm aufweist.

13. Photovoltaikvorrichtung (200), die mindestens die folgenden Schichten in Folge umfasst:
- ein Glassubstrat (1);
- eine untere Antireflexschicht, die ausgehend vom Glassubstrat nacheinander umfasst
∘ eine Basisschicht aus einem Silizium-(Oxi)-Nitrid (2),
∘ eine mittlere Schicht aus einem Oxid von Zn und Sn (3),
∘ eine obere Schicht aus einem Zn-Oxid (4);
- eine Funktionsschicht (5) auf Silberbasis; und
- eine obere Antireflexschicht, die ausgehend von der Funktionsschicht auf Silberbasis nacheinander umfasst:
∘ eine erste Barriereschicht aus einem Oxid von Ni und Cr (6),
∘ eine zweite Barriereschicht aus einem mit Al dotierten Zn-Oxid (7), und
∘ eine Pufferschicht (8, 9);
- eine Schicht (10, 11) aus Photovoltaikmaterial; und
- eine Rückkontakt- oder Elektrodenschicht (12);
wobei die erste Barriereschicht aus einem Oxid von Ni und Cr (6) direkt in Kontakt mit der Funktionsschicht (5) auf Silberbasis angeordnet ist oder die erste Barriereschicht aus einem Oxid von Ni und Cr (6) von der Funktionsschicht (5) auf Silberbasis durch eine oder mehrere zusätzliche Barriereschichten getrennt ist.

14. Verfahren zur Herstellung einer transparenten Frontelektrode (100) für eine Photovoltaikvorrichtung nach einem der Ansprüche 1 bis 12, mit den Schritten
Bereitstellen eines Glassubstrats (1) und
nacheinander Aufbringen auf das Glassubstrat (1)
- einer unteren Antireflexionsschicht, die ausgehend vom Glassubstrat (1) nacheinander umfasst:
∘ eine Basisschicht aus einem Silizium-(Oxi)-Nitrid (2),
∘ eine mittlere Schicht aus einem Oxid von Zn und Sn (3),
∘ eine obere Schicht aus einem Zn-Oxid (4);
- einer Funktionsschicht (5) auf Silberbasis; und
- einer oberen Antireflexschicht, die ausgehend von der Funktionsschicht auf Silberbasis nacheinander umfasst:
∘ eine erste Barriereschicht aus einem Oxid von Ni und Cr (6),
∘ eine zweite Barriereschicht aus einem mit Al dotierten Zn-Oxid (7), und
∘ eine Pufferschicht (8, 9);
wobei die erste Barriereschicht aus einem Oxid von Ni und Cr (6) direkt in Kontakt mit der Funktionsschicht (5) auf Silberbasis angeordnet wird oder die erste Barriereschicht aus einem Oxid von Ni und Cr (6) von der Funktionsschicht (5) auf Silberbasis durch eine oder mehrere zusätzliche Barriereschichten getrennt wird.

15. Organische lichtemittierende Diode (OLED), umfassend
- ein Glassubstrat (1);
- eine untere Antireflexschicht, die ausgehend vom Glassubstrat (1) nacheinander umfasst:
∘ eine Basisschicht aus einem Silizium-(Oxi)-Nitrid (2),
∘ eine mittlere Schicht aus einem Oxid von Zn und Sn (3),
∘ eine obere Schicht aus einem Zn-Oxid (4);
- eine Funktionsschicht (5) auf Silberbasis; und
- eine obere Antireflexschicht, die ausgehend von der Funktionsschicht auf Silberbasis nacheinander umfasst:
∘ eine erste Barriereschicht aus einem Oxid von Ni und Cr (6),
∘ eine zweite Barriereschicht aus einem mit Al dotierten Zn-Oxid (7), und
∘ eine Pufferschicht (8, 9);
wobei die erste Barriereschicht aus einem Oxid von Ni und Cr (6) direkt in Kontakt mit der Funktionsschicht (5) auf Silberbasis angeordnet ist oder die erste Barriereschicht aus einem Oxid von Ni und Cr (6) von der Funktionsschicht (5) auf Silberbasis durch eine oder mehrere zusätzliche Barriereschichten getrennt ist.

## Revendications

1. Electrode avant transparente (100) pour un dispositif photovoltaïque comprenant au moins les couches suivantes dans l'ordre :
- un substrat de verre (1) ;
- une couche antireflet inférieure, comprenant dans l'ordre à partir du substrat de verre (1)
-- une couche de base d'un (oxy)nitrure de silicium (2),
-- une couche centrale d'un oxyde de Zn et de Sn (3),
-- une couche supérieure d'un oxyde de Zn (4) ;
- une couche fonctionnelle à base d'argent (5) ; et
- une couche antireflet supérieure comprenant dans l'ordre à partir de la couche fonctionnelle à base d'argent
-- une première couche barrière d'un oxyde de Ni et de Cr (6),
-- une seconde couche barrière d'un oxyde de Zn dopé à l'Al (7), et
-- une couche tampon (8, 9) ;
dans laquelle la première couche barrière d'un oxyde de Ni et de Cr (6) est située directement en contact avec la couche fonctionnelle à base d'argent (5) ou la première couche barrière d'un oxyde de Ni et de Cr (6) est séparée de la couche fonctionnelle à base d'argent (5) par une ou plusieurs couches barrières additionnelles.

2. Electrode selon la revendication 1, dans laquelle la couche de base d'un (oxy)nitrure de silicium (2) a une épaisseur de 15 à 55 nm.

3. Electrode selon la revendication 1 ou la revendication 2, dans laquelle la couche centrale d'un oxyde de Zn et de Sn (3) a une épaisseur de 3 à 12 nm.

4. Electrode selon une quelconque revendication précédente, dans laquelle la couche centrale d'un oxyde de Zn et de Sn (3) est située directement sur la couche de base d'un (oxy)nitrure de silicium (2).

5. Electrode selon une quelconque revendication précédente, dans laquelle la couche supérieure d'un oxyde de Zn (4) a une épaisseur de 3 à 12 nm.

6. Electrode selon une quelconque revendication précédente, dans laquelle la couche fonctionnelle à base d'argent (5) a une épaisseur de 5 à 11 nm.

7. Electrode selon une quelconque revendication précédente, dans laquelle la première couche barrière d'un oxyde de Ni et de Cr (6) a une épaisseur inférieure ou égale à 3 nm.

8. Electrode selon une quelconque revendication précédente, dans laquelle la seconde couche barrière d'un oxyde de Zn dopé à l'Al (7) dans la couche antireflet supérieure a une épaisseur de 0,5 à 20 nm.

9. Electrode selon une quelconque revendication précédente, dans laquelle lesdites couches barrières additionnelles comprennent une ou plusieurs couches de NiCr, NiCrOₓ, Ti, TiOₓ, Zr, ZrOₓ, InSnOₓ ou des combinaisons de celles-ci.

10. Electrode selon une quelconque revendication précédente, dans laquelle la couche antireflet supérieure a une épaisseur totale de 20 à 130 nm.

11. Electrode selon une quelconque revendication précédente, dans laquelle la couche tampon (8, 9) comprend une ou plusieurs couches d'un oxyde de Zn et de Sn et/ou de SnO₂.

12. Electrode selon une quelconque revendication précédente, dans laquelle la couche tampon (8, 9) a une épaisseur de 8 à 125 nm.

13. Dispositif photovoltaïque (200) comprenant au moins les couches suivantes dans l'ordre :
- un substrat de verre (1) ;
- une couche antireflet inférieure, comprenant dans l'ordre à partir du substrat de verre
-- une couche de base d'un (oxy)nitrure de silicium (2),
-- une couche centrale d'un oxyde de Zn et de Sn (3),
-- une couche supérieure d'un oxyde de Zn (4) ;
- une couche fonctionnelle à base d'argent (5) ;
- une couche antireflet supérieure comprenant dans l'ordre à partir de la couche fonctionnelle à base d'argent
-- une première couche barrière d'un oxyde de Ni et de Cr (6),
-- une seconde couche barrière d'un oxyde de Zn dopé à l'Al (7), et
-- une couche tampon (8, 9) ;
- une couche de matériel photovoltaïque (10, 11) ; et
- une couche de contact ou d'électrode arrière (12) ;
dans laquelle la première couche barrière d'un oxyde de Ni et de Cr (6) est située directement en contact avec la couche fonctionnelle à base d'argent (5) ou la première couche barrière d'un oxyde de Ni et de Cr (6) est séparée de la couche fonctionnelle à base d'argent (5) par une ou plusieurs couches barrières additionnelles.

14. Procédé de fabrication d'une électrode avant transparente (100) pour un dispositif photovoltaïque selon l'une quelconque des revendications 1 à 12 comprenant la fourniture d'un substrat de verre (1) et le fait d'appliquer successivement sur ledit substrat de verre (1)
- une couche antireflet inférieure, comprenant dans l'ordre à partir du substrat de verre (1)
-- une couche de base d'un (oxy)nitrure de silicium (2),
-- une couche centrale d'un oxyde de Zn et de Sn (3),
-- une couche supérieure d'un oxyde de Zn (4) ;
- une couche fonctionnelle à base d'argent (5) ; et
- une couche antireflet supérieure comprenant dans l'ordre à partir de la couche fonctionnelle à base d'argent
-- une première couche barrière d'un oxyde de Ni et de Cr (6),
-- une seconde couche barrière d'un oxyde de Zn dopé à l'Al (7), et
-- une couche tampon (8, 9) ;
dans lequel la première couche barrière d'un oxyde de Ni et de Cr (6) est située directement en contact avec la couche fonctionnelle à base d'argent (5) ou la première couche barrière d'un oxyde de Ni et de Cr (6) est séparée de la couche fonctionnelle à base d'argent (5) par une ou plusieurs couches barrières additionnelles.

15. Diode électroluminescente organique (DELO) comprenant
- un substrat de verre (1) ;
- une couche antireflet inférieure, comprenant dans l'ordre à partir du substrat en verre
-- une couche de base d'un (oxy)nitrure de silicium (2),
-- une couche centrale d'un oxyde de Zn et de Sn (3),
-- une couche supérieure d'un oxyde de Zn (4) ;
- une couche fonctionnelle à base d'argent (5) ;
- une couche antireflet supérieure comprenant dans l'ordre à partir de la couche fonctionnelle à base d'argent
-- une première couche barrière d'un oxyde de Ni et de Cr (6),
-- une seconde couche barrière d'un oxyde de Zn dopé à l'Al (7), et
-- une couche tampon (8, 9) ;
- une couche de matériau photovoltaïque (10, 11) ; et
- une couche de contact ou d'électrode arrière (12) ;
dans laquelle la première couche barrière d'un oxyde de Ni et de Cr (6) est située directement en contact avec la couche fonctionnelle à base d'argent (5) ou la première couche barrière d'un oxyde de Ni et de Cr (6) est séparée de la couche fonctionnelle à base d'argent (5) par une ou plusieurs couches barrières additionnelles.
